# EUROPÄISCHE PATENTSCHRIFT

(11) **EP 3 404 431 B1**
(45) Veröffentlichungstag und Bekanntmachung des Hinweises auf die Patenterteilung: **20.01.2021**
(21) Anmeldenummer: 18171469.2
(22) Anmeldetag: 09.05.2018
(51) Int. Cl.: G01R 31/317, G01D 3/08, H04B 3/46

(54) **VERFAHREN ZUR ÜBERWACHUNG EINES BETRIEBS EINER BINÄREN SCHNITTSTELLE UND ENTSPRECHENDE BINÄRE SCHNITTSTELLE**
METHOD FOR MONITORING AN OPERATION OF A BINARY INTERFACE AND RELATED BINARY INTERFACE
PROCÉDÉ DE SURVEILLANCE DU FONCTIONNEMENT D'UNE INTERFACE BINAIRE ET INTERFACE BINAIRE CORRESPONDANTE

(30) Priorität: 15.05.2017 DE 102017208171
(43) Veröffentlichungstag der Anmeldung: 21.11.2018
(73) Patentinhaber: Pepperl+Fuchs SE, 68307 Mannheim (DE)
(72) Erfinder: Weiskopf, Bernhard, 68309 Mannheim (DE); Sand, Michel, 69469 Weinheim (DE)
(74) Vertreter: Patent- und Rechtsanwälte Ullrich & Naumann

(56) Entgegenhaltungen:
- DE-A1-102012 205 289
- DE-A1-102014 014 309
- US-A1- 2005 038 623
- US-A1- 2011 084 723

## Beschreibung

Die Erfindung betrifft ein Verfahren zur Überwachung eines Betriebs einer binären Schnittstelle, wobei eine Quelle eine Information über einen Ausgang und mindestens zwei Leiter an einen Eingang einer Senke sendet, wobei ein mittels einer auf den Ausgang geschalteten Spannung definierbarer Signalspannungspegel entweder einen Ein-Zustand - positive Logik - oder einen Aus-Zustand - negative Logik - und ein bei vom Ausgang getrennter Spannung anliegender Grundspannungspegel entsprechend einen Aus- oder einen Ein-Zustand bedeutet, wobei eine Fehlererkennung hinsichtlich des Arbeitens des Ausgangs oder der Schnittstelle oder eine Querschlusserkennung hinsichtlich mindestens eines Leiters vorzugsweise über eine Überwachung der am Ausgang anliegenden Spannung erfolgt und wobei hierzu mindestens ein Testimpuls im Ein-Zustand auf den Ausgang geschaltet wird.

Des Weiteren ist eine binäre Schnittstelle, insbesondere zur Durchführung des obigen Verfahrens, mit einer Quelle und einer Senke angegeben, wobei die Quelle eine Information über einen Ausgang und mindestens zwei Leiter an einen Eingang der Senke sendet, wobei ein mittels einer auf den Ausgang geschalteten Spannung definierbarer Signalspannungspegel entweder einen Ein-Zustand - positive Logik - oder einen Aus-Zustand - negative Logik - und ein bei vom Ausgang getrennter Spannung anliegender Grundspannungspegel entsprechend einen Aus- oder einen Ein-Zustand bedeutet, wobei die Schnittstelle Mittel zur Fehlererkennung hinsichtlich des Arbeitens des Ausgangs oder der Schnittstelle oder zur Querschlusserkennung hinsichtlich mindestens eines Leiters vorzugsweise über eine Überwachung der am Ausgang anliegenden Spannung aufweist und wobei zur Fehlererkennung oder zur Querschlusserkennung mindestens ein Testimpuls im Ein-Zustand auf den Ausgang schaltbar ist.

Ein Verfahren zur Überwachung eines Betriebs einer binären Schnittstelle sowie eine entsprechende binäre Schnittstelle sind aus der DE 10 2012 205 289 A1 bekannt. Aus diesem Dokument ist eine als Sensor ausgebildete binäre Schnittstelle bekannt, mit der von einer Quelle eine Information über einen Ausgang und mindestens zwei Leiter an einen Eingang einer Senke gesendet wird. Der bekannte Sensor arbeitet auf der Basis einer positiven Logik, so dass das Anlegen eines Signalspannungspegels einen Ein-Zustand bedeutet. Des Weiteren erfolgt bei dem bekannten Sensor eine Querschlusserkennung, wobei das Spannungssignal am Ausgang A2 zurückgelesen wird. Mehrere Testimpulse Al werden im Ein-Zustand gemäß Fig. 3 des Dokuments auf den Ausgang geschaltet, wobei der Test- oder Abschaltimpuls den vollen Signalhub des Signalspannungspegels zwischen H und L durchläuft und wobei nach Abschalten des Test- oder Abschaltimpulses Al der Signalspannungspegel H wieder erreicht wird.

Ein entsprechendes Verfahren zur Überwachung eines Betriebs einer binären Schnittstelle ist ebenfalls aus dem Positionspapier CB24l, "Klassifizierung binärer 24-V-Schnittstellen ...", Edition 2.0, November 2016, des Zentralverband Elektrotechnik- und Elektronikindustrie bekannt. Im Abschnitt 5.3 dieser Veröffentlichung ist ein Interface Typ C gezeigt, wobei dieses Interface eine Quelle aufweist, die eine Information über einen Ausgang und mindestens zwei Leiter an einen Eingang einer Senke sendet. Im Ein-Zustand schaltet eine Quelle eine Versorgungsspannung auf den Ausgang. Im Aus-Zustand wird der Ausgang von der Versorgungsspannung getrennt. Im Ein-Zustand sendet die Quelle Testimpulse auf den Ausgang. Die korrekte Funktion des Ausgangs wird in der Quelle selbst überwacht. Die Senke muss die Testimpulse der Quelle ausblenden, um unbeabsichtigte Schaltvorgänge zu vermeiden. Ein Versagen der Ausgangsschalteinrichtung, bspw. bei einem Haftfehler, wird in der Quelle erkannt, nicht aber in der Senke.

Weiterhin ist eine bekannte binäre Schnittstelle, bspw. für eine speicherprogrammierbare Steuerung SPS, in der Europäischen Norm EN 61131-2 beschrieben.

Bei den bekannten Verfahren und Schnittstellen, bspw. gemäß der DE 10 2012 205 289 A1, werden relativ lange Testimpulse verwendet, die den gesamten Signalhub zwischen Signalspannungspegel H und Grundspannungspegel L durchlaufen. Ein derart großer Signalhub erzeugt eine verhältnismäßig hohe Störaussendung, wobei durch den großen Signalhub des Weiteren das Energieniveau in den Eingängen sinkt. Weiterhin besteht bei den Testimpulsen mit großem Signalhub die Gefahr von Fehlsignalen bei Eingängen mit kurzer Reaktionszeit. Zusätzlich reduzieren große kapazitive Lasten, bspw. durch lange Leitungen, die Verfügbarkeit der Schnittstelle, da lange Testimpulse erforderlich sind, um den vollen Signalhub zu durchlaufen. Mit anderen Worten liegt in einem solchen Fall am Eingang über eine lange Zeit kein geeigneter erforderlicher Signalspannungspegel an.

Der vorliegenden Erfindung liegt daher die Aufgabe zugrunde, ein Verfahren zur Überwachung eines Betriebs einer binären Schnittstelle sowie eine entsprechende binäre Schnittstelle anzugeben, wonach eine sichere Überwachung eines Betriebs einer binären Schnittstelle ohne wesentliche Funktionsbeeinträchtigungen auf einfache Weise ermöglicht ist.

Erfindungsgemäß wird die voranstehende Aufgabe durch ein Verfahren zur Überwachung eines Betriebs einer binären Schnittstelle mit den Merkmalen des Anspruchs 1 sowie durch eine binäre Schnittstelle mit den Merkmalen des Anspruchs 10 gelöst. Danach sind das Verfahren und die Schnittstelle derart ausgestaltet und weitergebildet, dass der Betrag der durch den mindestens einen Testimpuls verursachten Änderung des Signalspannungspegels kleiner gewählt ist als der Betrag der Differenz zwischen dem Signalspannungspegel und dem Grundspannungspegel.

In erfindungsgemäßer Weise ist zunächst erkannt worden, dass durch geschickte Modifizierung des mindestens einen Testimpulses die voranstehende Aufgabe auf überraschend einfache Weise gelöst wird. In weiter erfindungsgemäßer Weise ist dann erkannt worden, dass eine sichere Überwachung eines Betriebs einer binären Schnittstelle auch mit mindestens einem Testimpuls möglich ist, der während der Testphase nicht den gesamten Signalhub zwischen Signalspannungspegel und Grundspannungspegel durchläuft. Vielmehr ist es erfindungsgemäß möglich, den Betrag der durch den mindestens einen Testimpuls verursachten Änderungen des Signalspannungspegels kleiner zu wählen als den Betrag der Differenz zwischen dem Signalspannungspegel und dem Grundspannungspegel. Hieraus ergeben sich vielfältige Vorteile. Zum einen werden Störaussendungen durch die verkleinerten Testimpulse reduziert, so dass sich die elektromagnetische Verträglichkeit, EMV, bei dem erfindungsgemäßen Verfahren und der erfindungsgemäßen Schnittstelle erhöht. Eine Verbesserung der Testimpuls-Verträglichkeit mit den Eingängen geht hiermit einher, da auch bei Eingängen mit kurzer Reaktionszeit die Wahrscheinlichkeit von Fehlsignalen durch die Testimpulse vermindert wird. Des Weiteren sinkt das Energieniveau in den Eingängen nicht so stark ab, wie bei Testimpulsen, die den gesamten Signalhub durchlaufen. Des Weiteren ist auch bei hohen kapazitiven Lasten durch bspw. lange Leitungen eine sichere Überwachung des Betriebs möglich, wobei die Verfügbarkeit der Schnittstelle erhöht ist.

Folglich ist mit dem erfindungsgemäßen Verfahren und der erfindungsgemäßen Schnittstelle eine sichere Überwachung eines Betriebs einer binären Schnittstelle ohne wesentliche Funktionsbeeinträchtigung auf einfache Weise ermöglicht.

Zur Realisierung einer besonders einfachen und effektiven Überwachung der Schnittstelle kann im Rahmen der Überwachung der am Ausgang anliegenden Spannung mit oder ab einem Beginn oder Schalten des mindestens einen Testimpulses die Spannung am Ausgang und eine Zeit gemessen werden, ab der der Testimpuls anliegt oder sich aufbaut. Zur Prüfung, ob sich die Spannung am Ausgang entsprechend der durch den Testimpuls bewirkten Änderung des Signalspannungspegels verhält oder ob möglicherweise ein Fehler, eine Fehlfunktion oder ein Querschluss, bspw. aufgrund eines Isolationsfehlers zwischen den Leitern, vorliegt, wird die sich am Ausgang verändernde Spannung gemessen und in Relation zur verstrichenen Zeit bewertet. Bei einem Erreichen oder Unterschreiten - positive Logik - ober Überschreiten - negative Logik - eines vordefinierten Testspannungspegels durch die Spannung innerhalb einer vordefinierten Zeitdauer, was einer positiven Bewertung der Überwachung oder Fehlerfreiheit entspricht, kann der Ein-Zustand wiederhergestellt und/oder ein geeignetes Positivsignal erzeugt werden. Sobald der Testspannungspegel also erreicht oder unterschritten oder überschritten wird, kann der Signalspannungspegel und damit der Ein-Zustand wiederhergestellt werden. In einem vorteilhaften Fall und bei nicht allzu kurzen Reaktionszeiten des Eingangs führt ein solcher Testimpuls zu keinem Fehlsignal am Eingang.

Falls der vordefinierte Testspannungspegel innerhalb der vordefinierten Zeitdauer nicht erreicht, unterschritten bzw. überschritten wird, wird der Aus-Zustand hergestellt und/oder ein Fehlersignal erzeugt. In diesem Fall ist ein Fehler oder ein Querschluss erkannt, so dass kein Ein-Zustand mehr vorliegen darf.

An dieser Stelle darf ergänzend erläutert werden, dass bei der Anspruchsformulierung die Vorgaben "Erreichen" oder "Unterschreiten" des vordefinierten Testspannungspegels im Falle einer positiven Logik mit einem hohen Ein-Signal relevant sind und die Vorgaben "Erreichen" oder "Überschreiten" des vordefinierten Testspannungspegels im Falle einer negativen Logik mit niedrigem Ein-Zustand relevant sind. Insofern umfasst die beanspruchte Lehre Verfahren und Schnittstellen mit einerseits positiver und andererseits negativer Logik.

Sowohl das oben erwähnte Positivsignal als auch das oben erwähnte Fehlersignal kann durch ein optisches, akustisches oder elektrisches Signal, vorzugsweise in Verbindung mit einer Anzeigeeinrichtung, gebildet sein.

In besonders vorteilhafter Weise kann der Testspannungspegel zwischen dem Signalspannungspegel und dem Grundspannungspegel liegen. Hierdurch ist gewährleistet, dass der Betrag, der durch den mindestens einen Testimpuls verursachten Änderung des Signalspannungspegels kleiner ist als der Betrag der Differenz zwischen dem Signalspannungspegel und dem Grundspannungspegel. Mit anderen Worten ist der Testspannungspegel in vorteilhafter Weise derart gewählt, dass ein Testimpuls nicht den gesamten Signalhub zwischen Signalspannungspegel und Grundspannungspegel durchlaufen muss.

Bei binären Schnittstellen ist es üblich, dass sowohl der Ein-Zustand als auch der Aus-Zustand vorliegt und als solcher von anderen elektronischen Bauteilen erkannt wird und Berücksichtigung findet, solange sich der jeweilige Signalspannungspegel oder Grundspannungspegel in einem entsprechenden, definierbaren Spannungspegelbereich befindet. Geringfügige Schwankungen des Signalspannungspegels oder Grundspannungspegels führen folglich nicht sofort zu ungewünschten Fehlsignalen oder Fehlschaltungen, solange sich Signalspannungspegel oder Grundspannungspegel noch in dem vorgegebenen zugehörigen Spannungspegelbereich befinden. Im Hinblick auf eine besonders effektive Vermeidung von Fehlsignalen oder Fehlschaltungen am Eingang der Senke kann der Testspannungspegel daher in einem Spannungspegelbereich für den Ein-Zustand (positive Logik) oder den Aus-Zustand (negative Logik) oder dicht bei dem Spannungspegelbereich für den Ein-Zustand (positive Logik) oder den Aus-Zustand (negative Logik) liegen. Hierdurch wird in vorteilhafter Weise gewährleistet, dass der Eingang den mindestens einen Testimpuls und die hierdurch verursachte Änderung des Signalspannungspegels quasi nicht wahrnimmt.

Bei einer alternativen Realisierung des erfindungsgemäßen Verfahrens werden in vorteilhafter Weise ebenfalls mit oder ab einem Beginn oder Schalten des mindestens einen Testimpulses die Spannung am Ausgang und eine Zeit gemessen, ab welcher der Testimpuls beginnt oder sich aufbaut. Bei diesem alternativen Verfahren wird jedoch nicht ein vordefinierter Testspannungspegel als Grenze für ein Erreichen oder Überschreiten oder Unterschreiten der sich nach Schalten des Testimpulses ergebenden Spannung berücksichtigt, sondern eine Differenz zwischen dem vor dem Beginn oder Schalten des mindestens einen Testimpulses im Ein-Zustand am Ausgang anliegenden Spannungspegel und einem vordefinierten Differenzspannungspegel. Bei einem Erreichen oder Überschreiten eines Betrags dieses vordefinierten Spannungsintervalls, das durch die Differenz zwischen dem vor dem Beginn oder Schalten des mindestens einem Testimpulses im Ein-Zustand am Ausgang anliegenden Spannungspegel und einem vordefinierten Differenzspannungspegel definiert wird, durch die Spannung innerhalb einer vordefinierten Zeitdauer wird der Ein-Zustand wiederhergestellt und/oder ein geeignetes Positivsignal erzeugt. Andernfalls, falls der Betrag des vordefinierten Spannungsintervalls nicht innerhalb der vordefinierten Zeitdauer durch die Spannung erreicht oder überschritten wird, wird der Aus-Zustand hergestellt und/oder ein Fehlersignal erzeugt. Im letztgenannten Fall ist ein Fehler oder ein Querschluss erkannt.

In vorteilhafter Weise kann der Differenzspannungspegel - wie der bei der ersten vorteilhaften Realisierung des Verfahrens definierte Testspannungspegel - zwischen dem Signalspannungspegel und dem Grundspannungspegel liegen. Hierdurch wird wiederum gewährleistet, dass nicht der gesamte Signalhub durch den Testimpuls durchlaufen werden muss. Entsprechende bereits oben erfolgte Ausführungen zur ersten vorteilhaften Realisierung des Verfahrens gelten entsprechend auch für die alternative vorteilhafte Realisierung des Verfahrens.

In gleicher Weise kann der Differenzspannungspegel in vorteilhafter Weise in einem Spannungspegelbereich für den Ein-Zustand oder den Aus-Zustand oder dicht bei dem Spannungspegelbereich für den Ein-Zustand oder den Aus-Zustand liegen. Auch bezüglich dieser vorteilhaften Ausgestaltung darf zur Vermeidung von Wiederholungen auf die entsprechenden Ausführungen zur ersten vorteilhaften Realsierung des erfindungsgemäßen Verfahrens verwiesen werden, die in analoger Weise gelten.

In vorteilhafter Weise ist die vordefinierte Zeitdauer die maximale Dauer des Testimpulses. Der Testimpuls muss nicht länger sein, da bereits nach der vordefinierten Zeitdauer bewertet werden kann, ob ein Fehler oder ein Querschluss vorliegt. Die vordefinierte Zeitdauer kann in entsprechender Weise und in Abhängigkeit von dem jeweiligen Anwendungsfall mit den jeweils vorliegenden Kapazitäten und elektronischen Bausteinen definiert werden.

In vorteilhafter Weise kann eine Querschlusserkennung zwischen zwei einzelnen Leitern erkannt werden. Alternativ oder zusätzlich hierzu kann eine Querschlusserkennung zwischen einem Leiter und einer Masseleitung und/oder Versorgungsleitung erfolgen. Das erfindungsgemäße Verfahren und die erfindungsgemäße Schnittstelle sind für beide Situationen geeignet.

Es gibt nun verschiedene Möglichkeiten, die Lehre der vorliegenden Erfindung in vorteilhafter Weise auszugestalten und weiterzubilden. Dazu ist einerseits auf die nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: in einem Diagramm einen schematischen Aufbau einer herkömmlichen Schnittstelle, die hinsichtlich ihrer Grundstruktur zur Durchführung der Ausführungsbeispiele des erfindungsgemäßen Verfahrens geeignet ist, und
- Fig. 2: ein Diagramm mit einem Testimpulsverlauf gemäß der Erfindung.

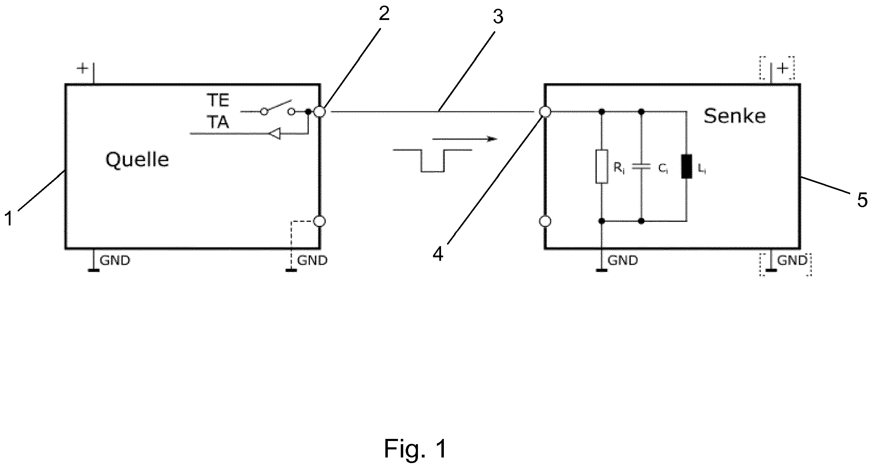

Fig. 1 zeigt in einer schematischen Darstellung eine herkömmliche Schnittstelle, die hinsichtlich ihrer Grundstruktur zur Durchführung des erfindungsgemäßen Verfahrens geeignet ist. Die Schnittstelle ist zur Überwachung eines Betriebs der Schnittstelle ausgebildet, wobei eine Quelle 1 eine Information über einen Ausgang 2 und mindestens zwei Leiter 3 an einen Eingang 4 einer Senke 5 sendet. Der Einfachheit der Darstellung halber sind die beiden Leiter 3 mit nur einem durchgezogenen Strich dargestellt. Die Quelle 1 ist mit einer Versorgungsspannung "+" versorgt und mit einer Masse GND geerdet. Die Quelle 1 weist des Weiteren eine Testimpulserzeugung TE und eine Testimpulsauswertung TA auf. Eine Information wird in Form eines binären Signals an den Eingang 4 der Senke 5 übermittelt, wobei eine derartige binäre Information durch ein entsprechendes Symbol zwischen der Quelle 1 und der Senke 5 in Fig. 1 dargestellt ist. Die Senke 5 weist einen ohmschen Widerstand Rᵢ, eine Lastkapazität Cᵢ und eine induktive Last Lᵢ auf.

Die Überwachung des Betriebs der Schnittstelle findet in der Quelle 1 statt. Die Senke 5 muss im Hinblick auf eine sichere Funktion die Testimpulse der Quelle 1 möglichst ausblenden, um unbeabsichtigte Schaltvorgänge zu vermeiden.

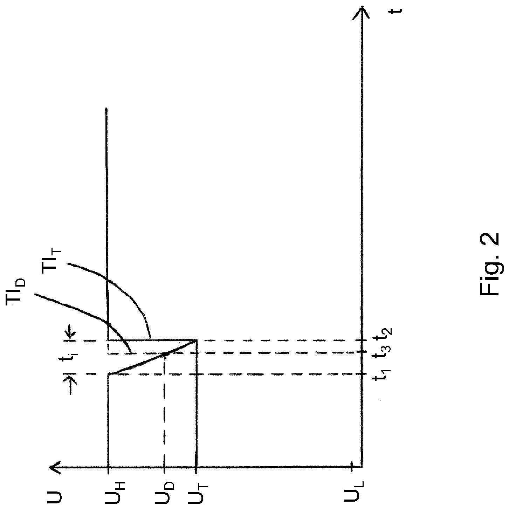

Fig. 2 zeigt in einem Diagramm einen Verlauf eines Signalspannungspegels U_{H} in Abhängigkeit von der Zeit t. Der Signalspannungspegel U_{H} ist mittels einer auf den Ausgang 2 geschalteten Spannung definiert, wobei bei dem hier gezeigten Ausführungsbeispiel eine positive Logik zugrundegelegt ist, so dass der Signalspannungspegel U_{H} einen Ein-Zustand darstellt. Der entsprechende Aus-Zustand wird durch einen Grundspannungspegel U_{L} dargestellt.

Zur Überwachung des Betriebs der Schnittstelle und im Hinblick auf eine Fehlererkennung oder Querschlusserkennung wird ein Testimpuls TI_{T} - mit durchgezogener Linie dargestellt - im Ein-Zustand auf den Ausgang 2 geschaltet. Dies findet gemäß dem Diagramm in Fig. 2 zum Zeitpunkt t₁ statt. Im Gegensatz zum Stand der Technik durchläuft der Testimpuls TI_{T} nicht den gesamten Signalhub zwischen U_{H} und U_{L}, sondern einen wesentlich kürzeren Differenzspannungsbetrag. Mit anderen Worten ist bei dem erfindungsgemäßen Verfahren der Betrag der durch den mindestens einen Testimpuls TI_{T} verursachten Änderung des Signalspannungspegels U_{H} kleiner als der Betrag der Differenz zwischen dem Signalspannungspegel U_{H} und dem Grundspannungspegel U_{L}.

Mit Beginn des Testimpulses TI_{T}, d.h. ab dem Zeitpunkt t₁, wird die Spannung am Ausgang 2 und gleichzeitig die Zeit gemessen, wobei bei einem Erreichen eines vordefinierten Testspannungspegels U_{T} durch die Spannung innerhalb einer vordefinierten Zeitdauer tᵢ der Ein-Zustand wiederhergestellt wird - Zeitpunkt t₂. Die maximale Dauer des Testimpulses TI_{T} ist die Zeitdauer tᵢ, die gemäß Fig. 2 der Zeitdauer t₂ - t₁ entspricht. Der Testspannungspegel U_{T} liegt zwischen dem Signalspannungspegel U_{H} und dem Grundspannungspegel U_{L}.

In Fig. 2 ist noch ein weiterer Zeitpunkt t₃ dargestellt, der zu einem Differenzspannungspegel U_{D} korrespondiert. Der Differenzspannungspegel U_{D} bezieht sich auf eine alternative Realisierung des erfindungsgemäßen Verfahrens, wobei hier kein absoluter Spannungspegel in Form des Testspannungspegels U_{T} definiert ist, sondern ein relativer Spannungspegel, nämlich der Differenzspannungspegel U_{D} mit einem zugehörigen Testimpuls TI_{D}, der teilweise gestrichelt dargestellt ist. Mit dem Differenzspannungspegel U_{D} wird eine Differenz, bspw. 1 Volt, zu dem Signalspannungspegel U_{H} definiert. Das bedeutet, dass bei einer Veränderung des Signalspannungspegels U_{H} sich auch der Differenzspannungspegel U_{D} verändert. Der zuvor beschriebene Testspannungspegel U_{T} wäre im Gegensatz hierzu als absoluter Spannungswert gemäß dem ersten Ausführungsbeispiel des erfindungsgemäßen Verfahrens fixiert. Dem Grunde nach entsprechen sich beide Ausführungsbeispiele - Verwendung eines absoluten Testspannungspegels U_{T} oder Verwendung eines Differenzspannungspegels U_{D} - hinsichtlich der Grundidee der Erfindung, dass der Betrag der durch den mindestens einen Testimpuls TI_{T} oder TI_{D} verursachten Änderung des Signalspannungspegels U_{H} kleiner ist als der Betrag der Differenz zwischen dem Signalspannungspegel U_{H} und dem Grundspannungspegel U_{L.}.

Auch der Differenzspannungspegel U_{D} liegt zwischen dem Signalspannungspegel U_{H} und dem Grundspannungspegel U_{L}, wobei der Differenzspannungspegel U_{D} in besonders vorteilhafter Weise in einem Spannungspegelbereich für den Ein-Zustand oder dicht bei dem Spannungspegelbereich für den Ein-Zustand liegen kann.

Gemäß Fig. 2 ist die Dauer des Testimpulses TI_{D} im Falle des zweiten Ausführungsbeispiels die Differenz zwischen den zwei Zeitpunkten t₃ und t₁.

Bei geschickter Wahl des Testspannungspegels U_{T} und des Differenzspannungspegels U_{D} unterschreiten die Testimpulse die untere Grenze für den Ein-Zustand nur sehr kurz oder gar nicht. Auch Eingänge 4 mit kurzer Reaktionszeit werden die Testimpulse TI_{T} oder TI_{D} in diesem Fall nicht wahrnehmen. Des Weiteren ist der Störabstand der erfindungsgemäß kleineren Testimpulse TI_{T} und TI_{D} größer als bei Testimpulsen mit großem oder vollständigem Signalhub oder langer Impulszeit.

Die Dauer der Testimpulse kann sich quasi automatisch der Lastimpedanz anpassen und ergibt dabei bei einem fehlerfreien Zustand stets die kürzest mögliche Impulszeit.

Hinsichtlich weiterer vorteilhafter Ausgestaltungen des erfindungsgemäßen Verfahrens und der erfindungsgemäßen Schnittstelle wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

### Bezugszeichenliste

- 1: Quelle
- 2: Ausgang
- 3: Leiter
- 4: Eingang
- 5: Senke
- Cᵢ: Lastkapazität
- GND: Masse
- Lᵢ: induktive Last
- Rᵢ: Widerstand
- t₁, t₂, t₃: Zeitpunkt
- TA: Testimpulsauswertung
- TE: Testimpulserzeugung
- tᵢ: Zeitdauer
- TI: Testimpuls
- U_{D}: Differenzspannungspegel
- U_{H}: Signalspannungspegel
- U_{L}: Grundspannungspegel
- U_{T}: Testspannungspegel

## Patentansprüche

1. Verfahren zur Überwachung eines Betriebs einer binären Schnittstelle, wobei eine Quelle (1) eine Information über einen Ausgang (2) und mindestens zwei Leiter (3) an einen Eingang (4) einer Senke (5) sendet, wobei ein mittels einer auf den Ausgang (2) geschalteten Spannung definierbarer Signalspannungspegel (U_{H}) entweder einen Ein-Zustand - positive Logik - oder einen Aus-Zustand - negative Logik - und ein bei vom Ausgang (2) getrennter Spannung anliegender Grundspannungspegel (U_{L}) entsprechend einen Aus- oder einen Ein-Zustand bedeutet, wobei eine Fehlererkennung hinsichtlich des Arbeitens des Ausgangs (2) oder der Schnittstelle oder eine Querschlusserkennung hinsichtlich mindestens eines Leiters (3) erfolgt und wobei hierzu mindestens ein Testimpuls (TI) im Ein-Zustand auf den Ausgang (2) geschaltet wird,
**dadurch gekennzeichnet, dass** der Betrag der durch den mindestens einen Testimpuls (TI_{T}, TI_{D}) verursachten Änderung des Signalspannungspegels (U_{H}) kleiner gewählt ist als der Betrag der Differenz zwischen dem Signalspannungspegel (U_{H}) und dem Grundspannungspegel (U_{L}).

2. Verfahren nach Anspruch 1, **dadurch gekennzeichnet, dass** mit oder ab einem Beginn oder Schalten des mindestens einen Testimpulses (TI_{T}) die Spannung am Ausgang (2) und eine Zeit gemessen werden und
dass bei einem Erreichen oder Unterschreiten - positive Logik - oder Überschreiten - negative Logik - eines vordefinierten Testspannungspegels (U_{T}) durch die Spannung innerhalb einer vordefinierten Zeitdauer (tᵢ) der Ein-Zustand wiederhergestellt und/oder ein geeignetes Positivsignal erzeugt wird und andernfalls der Aus-Zustand hergestellt und/oder ein Fehlersignal erzeugt wird.

3. Verfahren nach Anspruch 2, **dadurch gekennzeichnet, dass** der Testspannungspegel (U_{T}) zwischen dem Signalspannungspegel (U_{H}) und dem Grundspannungspegel (U_{L}) liegt.

4. Verfahren nach einem der Ansprüche 2 oder 3, **dadurch gekennzeichnet, dass** der Testspannungspegel (U_{T}) in einem Spannungspegelbereich für den Ein-Zustand oder den Aus-Zustand oder dicht bei dem Spannungspegelbereich für den Ein-Zustand oder den Aus-Zustand liegt.

5. Verfahren nach Anspruch 1, **dadurch gekennzeichnet, dass** mit oder ab einem Beginn oder Schalten des mindestens einen Testimpulses (TI_{D}) die Spannung am Ausgang (2) und eine Zeit gemessen werden und
dass bei einem Erreichen oder Überschreiten eines Betrags eines vordefinierten Spannungsintervalls, das durch die Differenz zwischen dem vor dem Beginn oder Schalten des mindestens einen Testimpulses (TI_{D}) im Ein-Zustand am Ausgang (2) anliegenden Spannungspegel und einem vordefinierten Differenzspannungspegel (U_{D}) definiert wird, durch die Spannung innerhalb einer vordefinierten Zeitdauer (tᵢ) der Ein-Zustand wiederhergestellt und/oder ein geeignetes Positivsignal erzeugt wird und andernfalls der Aus-Zustand hergestellt und/oder ein Fehlersignal erzeugt wird.

6. Verfahren nach Anspruch 5, **dadurch gekennzeichnet, dass** der Differenzspannungspegel (U_{D}) zwischen dem Signalspannungspegel (U_{H}) und dem Grundspannungspegel (U_{L}) liegt.

7. Verfahren nach Anspruch 5 oder 6, **dadurch gekennzeichnet, dass** der Differenzspannungspegel (U_{D}) in einem Spannungspegelbereich für den Ein-Zustand oder den Aus-Zustand oder dicht bei dem Spannungspegelbereich für den Ein-Zustand oder den Aus-Zustand liegt.

8. Verfahren nach einem der Ansprüche 2 bis 7, **dadurch gekennzeichnet, dass** die Zeitdauer (tᵢ) die maximale Dauer des Testimpulses (TI_{T}, TI_{D}) ist.

9. Verfahren nach einem der Ansprüche 1 bis 8, **dadurch gekennzeichnet, dass** eine Querschlusserkennung zwischen zwei einzelnen Leitern (3) und/oder zwischen einem Leiter (3) und einer Masseleitung und/oder Versorgungsleitung erfolgt.

10. Verfahren nach einem der Ansprüche 1 bis 9, **dadurch gekennzeichnet, dass** die Fehlererkennung über eine Überwachung der am Ausgang (2) anliegenden Spannung erfolgt.

11. Binäre Schnittstelle zur Durchführung des Verfahrens nach einem der Ansprüche 1 bis 10, mit einer Quelle (1) und einer Senke (5), wobei die Quelle (1) eine Information über einen Ausgang (2) und mindestens zwei Leiter (3) an einen Eingang (4) der Senke (5) sendet, wobei ein mittels einer auf den Ausgang (2) geschalteten Spannung definierbarer Signalspannungspegel (U_{H}) entweder einen Ein-Zustand - positive Logik - oder einen Aus-Zustand - negative Logik - und ein bei vom Ausgang (2) getrennter Spannung anliegender Grundspannungspegel (U_{L}) entsprechend einen Aus- oder einen Ein-Zustand bedeutet, wobei die Schnittstelle Mittel zur Fehlererkennung hinsichtlich des Arbeitens des Ausgangs (2) oder der Schnittstelle oder zur Querschlusserkennung hinsichtlich mindestens eines Leiters (3) aufweist und wobei zur Fehlererkennung oder zur Querschlusserkennung mindestens ein Testimpuls (TI_{T}, TI_{D}) im Ein-Zustand auf den Ausgang (2) schaltbar ist, **dadurch gekennzeichnet, dass** der Betrag der durch den mindestens einen Testimpuls (TI_{T}, TI_{D}) verursachten Änderung des Signalspannungspegels (U_{H}) kleiner gewählt ist als der Betrag der Differenz zwischen dem Signalspannungspegel (U_{H}) und dem Grundspannungspegel (U_{L}).

12. Schnittstelle nach Anspruch 11, **dadurch gekennzeichnet, dass** die Fehlererkennung über eine Überwachung der am Ausgang (2) anliegenden Spannung realisiert ist.

## Claims

1. Method for monitoring an operation of a binary interface, wherein a source (1) transmits an information item via an output (2) and at least two conductors (3) to an input of a sink (5), wherein a signal voltage level (U_{H}) which can be defined by means of a voltage switched to the output (2) means either an on state - positive logic - or an off state - negative logic - and a basic voltage level (U_{L}) which is applied when voltage is separated from the output (2) accordingly means an off state or an on state, wherein an error identification with regard to the working of the output (2) or the interface or a cross-wire identification with regard to at least one conductor (3) is carried out and wherein to this end at least one test pulse (TI) is switched in the on state to the output (2),
**characterised in that** the value of the change of the signal voltage level (U_{H}) is selected to be smaller than the value of the difference between the signal voltage level (U_{H}) and the basic voltage level (U_{L}), which change is caused by the at least one test pulse (TI_{T}, TI_{D}) .

2. Method according to claim 1, **characterised in that** with or from a beginning or switching of the at least one test pulse (TI_{T}) the voltage at the output (2) and a time are measured, and **in that**, when the voltage reaches or falls below a predefined test voltage level (U_{T})- positive logic - or exceeds it - negative logic - within a predefined period of time (tᵢ), the on state is reproduced and/or a suitable positive signal is produced and otherwise the off state is produced and/or an error signal is produced.

3. Method according to claim 2, **characterised in that** the test voltage level (U_{T}) is between the signal voltage level (U_{H}) and the basic voltage level (U_{L}) .

4. Method according to either claim 2 or claim 3,
**characterised in that** the test voltage level (U_{T}) is in a voltage level range for the on state or the off state or is close to the voltage level range for the on state or the off state.

5. Method according to claim 1, **characterised in that** with or from a beginning or switching of the at least one test pulse (TI_{D}) the voltage at the output (2) and a time are measured, and **in that**, when a value of a predefined voltage range which is defined by the difference between the voltage level applied prior to the beginning or switching of the at least one test pulse (TI_{D}) in the on state at the output (2) and a predefined differential voltage level (U_{D}), is reached or exceeded, as a result of the voltage within a predefined period of time (tᵢ) the on state is reproduced and/or a suitable positive signal is produced and otherwise the off state is produced and/or an error signal is produced.

6. Method according to claim 5, **characterised in that** the differential voltage level (U_{D}) is between the signal voltage level (U_{H}) and the basic voltage level (U_{L}).

7. Method according to claim 5 or 6, **characterised in that** the differential voltage level (U_{D}) is in a voltage level range for the on state or the off state or is close to the voltage level range for the on state or the off state.

8. Method according to any one of claims 2 to 7,
**characterised in that** the time period (tᵢ) is the maximum duration of the test pulse (TI_{T}, TI_{D}) .

9. Method according to any one of claims 1 to 8,
**characterised in that** a cross-wire identification between two individual conductors (3) and/or between a conductor (3) and a ground line and/or supply line is carried out.

10. Method according to any one of claims 1 to 9,
**characterised in that** the error identification is carried out by means of monitoring of the voltage applied at the output (2) .

11. Binary interface for carrying out the method according to any one of claims 1 to 10, having a source (1) and a sink (5), wherein the source (1) transmits an information item via an output (2) and at least two conductors (3) to an input (4) of the sink (5), wherein a signal voltage level (U_{H}) which can be defined by means of a voltage which is switched to the output (2) means either an on state - positive logic - or an off state - negative logic - and a basic voltage level (U_{L}) which is applied when voltage is separated from the output (2) accordingly means an off state or an on state, wherein the interface has means for error identification with regard to the working of the output (2) or the interface or the cross-wire identification with regard to at least one conductor (3), and wherein for error identification or for cross-wire identification at least one test pulse (TI_{T}, TI_{D}) can be switched in the one state to the output (2), **characterised in that** the value of the change of the signal voltage level (U_{H}) is selected to be smaller than the value of the difference between the signal voltage level (U_{H}) and the basic voltage level (U_{L}), which change is caused by the at least one test pulse (TI_{T}, TI_{D}) .

12. Interface according to claim 11, **characterised in that** the error identification is carried out by means of monitoring of the voltage applied at the output (2).

## Revendications

1. Procédé de surveillance du fonctionnement d'une interface binaire, dans lequel une source (1) émet une information par l'intermédiaire d'une sortie (2) et au moins deux conducteurs (3) à une entrée (4) d'un puits (5), dans lequel un niveau de tension de signal (U_{H}), pouvant être défini au moyen d'une tension appliquée à la sortie (2), signifie soit un état activé - logique positive - soit un état désactivé - logique négative - et un niveau de tension de base (U_{L}), appliqué lorsque la tension est déconnectée de la sortie (2), signifie de manière correspondante un état désactivé ou un état activé, dans lequel une détection d'erreur relative au fonctionnement de la sortie (2) ou de l'interface ou une détection de court-circuit relative à au moins un conducteur (3) a lieu et dans lequel, pour cela, au moins une impulsion de test (TI) est appliquée dans l'état activé à la sortie (2),
**caractérisé en ce que** la valeur absolue de la modification du niveau de tension de signal (U_{H}) provoquée par l'au moins une impulsion de test (TI_{T}, TI_{D}) est choisie de façon à être inférieure à la valeur absolue de la différence entre le niveau de tension de signal (U_{H}) et le niveau de tension de base (U_{L}).

2. Procédé selon la revendication 1, **caractérisé en ce que** lors ou à partir du début ou de l'application de l'au moins une impulsion de test (TI_{T}), la tension à la sortie (2) et un temps sont mesurés et
lorsqu'on atteint ou passe en dessous - logique positive - ou lors du dépassement - logique négative - d'un niveau de tension de test (U_{T}) prédéfini par la tension dans une période (tᵢ) prédéfinie, l'état activé est restauré et/ou un signal positif adapté est généré, sinon l'état désactivé est établi et/ou un signal d'erreur est généré.

3. Procédé selon la revendication 2, **caractérisé en ce que** le niveau tension de test (U_{T}) se trouve entre le niveau de tension de signal (U_{H}) et le niveau de tension de base (U_{L}).

4. Procédé selon l'une des revendications 2 ou 3, **caractérisé en ce que** le niveau de tension de test (U_{T}) se trouve dans une plage de niveaux de tension pour l'état activé ou l'état désactivé ou près de la plage de niveaux de tension pour l'état activé ou l'état désactivé.

5. Procédé selon la revendication 1, **caractérisé en ce que**, lors ou à partir du début ou de l'application de l'au moins une impulsion de test (TI_{D}), la tension à la sortie (2) et un temps sont mesurés et
lorsqu'on atteint ou dépasse une valeur absolue d'un intervalle de tension prédéfini, qui est définie par la différence entre le niveau de tension appliqué lors ou avant le début ou l'application de l'au moins une impulsion de test (TI_{D}) dans l'état activé à la sortie (2) et un niveau de tension différentielle prédéfini (U_{D}), grâce à la tension dans une période (tᵢ) prédéfinie, l'état activé est restauré et/ou un signal positif adapté est généré, sinon l'état désactivé est établi et/ou un signal d'erreur est généré.

6. Procédé selon la revendication 5, **caractérisé en ce que** le niveau de tension différentielle (U_{D}) se trouve entre le niveau de tension de signal (U_{H}) et le niveau de tension de base (U_{L}).

7. Procédé selon la revendication 5 ou 6, **caractérisé en ce que** le niveau de tension différentielle (U_{D}) se trouve dans une plage de niveaux de tension pour l'état activé ou l'état désactivé ou près de la plage de niveaux de tension pour l'état activé ou l'état désactivé.

8. Procédé selon l'une des revendications 2 à 7, **caractérisé en ce que** la période (tᵢ) est la durée maximale de l'impulsion de test (TI_{T}, TI_{D}).

9. Procédé selon l'une des revendications 1 à 8, **caractérisé en ce qu'**une détection de court-circuit entre deux conducteurs (3) et/ou entre un conducteur (3) et une ligne de masse et/ou une ligne d'alimentation a lieu.

10. Procédé selon l'une des revendications 1 à 9, **caractérisé en ce que** la détection d'erreur a lieu par l'intermédiaire d'une surveillance de la tension appliquée à la sortie (2).

11. Interface binaire pour l'exécution du procédé selon l'une des revendications 1 à 10, avec une source (1) et un puits (5), dans lequel la source (1) émet une information par l'intermédiaire d'une sortie (2), et au moins deux conducteurs (3) à une entrée (4) du puits (5), dans lequel un niveau de tension de signal (U_{H}), pouvant être défini au moyen d'une tension appliquée à la sortie (2), signifie soit un état activé - logique positive - soit un état désactivé - logique négative - et un niveau de tension de base (U_{L}), appliqué lorsque la tension est déconnectée de la sortie (2), signifie de manière correspondante un état désactivé ou un état activé, dans lequel l'interface comprend des moyens pour la détection d'erreur relative au fonctionnement de la sortie (2) ou de l'interface ou une détection de court-circuit relative à au moins un conducteur (3) a lieu et dans lequel, pour la détection d'erreur ou pour la détection de court-circuit, au moins une impulsion de test (TI_{T}, TI_{D}) peut être appliquée dans l'état activé à la sortie (2),
**caractérisée en ce que** la valeur absolue de la modification du niveau de tension de signal (U_{H}) provoquée par l'au moins une impulsion de test (TI_{T}, TI_{D}) est choisie de façon à être inférieure à la valeur absolue de la différence entre le niveau de tension de signal (U_{H}) et le niveau de tension de base (U_{L}).

12. Interface selon la revendication 11, **caractérisée en ce que** la détection d'erreur est réalisée par l'intermédiaire d'une surveillance de la tension appliquée à la sortie (2).
